# EUROPÄISCHE PATENTANMELDUNG

(11) **EP 2 844 051 A2**
(43) Veröffentlichungstag der Anmeldung: **04.03.2015**
(21) Anmeldenummer: 14176903.4
(22) Anmeldetag: 14.07.2014
(51) Int. Cl.: H05K 7/20

(54) **Leistungshalbleitereinrichtung und Verfahren zur Herstellung einer Leistungshalbleitereinrichtung**

(30) Priorität: 03.09.2013 DE 102013109589
(71) Anmelder: SEMIKRON Elektronik GmbH & Co. KG, 90431 Nürnberg (DE)
(72) Erfinder: Bogen, Ingo, 90425 Nürnberg (DE); Beck, Markus, 92318 Neumarkt (DE); Kulas, Hartmut, 90562 Heroldsberg (DE); Popescu, Alexander, 90763 Fürth (DE); Helldörfer, Reinhard, 91083 Baiersdorf (DE)

(57) **Zusammenfassung**

Die Erfindung betrifft eine Leistungshalbleitereinrichtung mit einem Leistungshalbleitermodul und einem Kühlkörper, wobei der Kühlkörper ein erstes Kühlgehäusebauteil, das eine durch das erste Kühlgehäusebauteil hindurchgehende Ausnehmung aufweist und ein zweites Kühlgehäusebauteil aufweist, wobei die Kühlplatte in der Ausnehmung angeordnet ist, wobei das erste und das zweite Kühlgehäusebauteil eine derartige Form aufweisen und derartig zueinander angeordnet sind, dass sich ein Hohlraum an der den Leistungshalbleiterbauelementen abgewandten Seite der Kühlplatte ausbildet, wobei die Kühlplatte mittels einer um die Kühlplatte umlaufenden ersten Schweißnaht mit dem ersten Kühlgehäusebauteil verbunden ist, wobei die erste Schweißnaht die Kühlplatte gegen das erste Kühlgehäusebauteil abdichtet, wobei das zweite Kühlgehäusebauteil mit dem ersten Kühlgehäusebauteil verbunden ist. Weiterhin betrifft die Erfindung ein Verfahren zur Herstellung einer Leistungshalbleitereinrichtung. Die Erfindung schafft eine Leistungshalbleitereinrichtung, die eine gute Wärmeleitung von den Leistungshalbleiterbauelementen zu einem von einem Flüssigkeit durchströmbaren Kühlkörper der Leistungshalbleitereinrichtung aufweist und bei der der Kühlkörper langfristig und zuverlässig dicht ist.

## Beschreibung

Die Erfindung betrifft eine Leistungshalbleitereinrichtung. Weiterhin betrifft die Erfindung ein Verfahren zur Herstellung einer Leistungshalbleitereinrichtung.

Bei aus dem Stand der Technik bekannten Leistungshalbleitereinrichtungen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor) vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Im Betrieb der Leistungshalbleitereinrichtung treten an den Leistungshalbleiterbauelementen elektrische Verluste auf, die zu einer Erwärmung der Leistungshalbleiterbauelemente führen. Zur Kühlung der Leistungshalbleiterbauelemente weisen technikübliche Leistungshalbleitereinrichtungen oftmals einen von einer Kühlflüssigkeit durchströmten Kühlkörper auf, der thermisch leitend an die Leistungshalbleiterbauelemente angekoppelt ist.

Aus der DE 10 2010 043 446 B3 ist es bekannt, einen von einer Kühlflüssigkeit durchströmten Kühlkörper mit Ausnehmungen zu versehen und in die Ausnehmungen die Kühlplatte von Leistungshalbleitermodulen, die Leistungshalbleiterbauelemente aufweisen, anzuordnen. Hierdurch wird eine gute Wärmeabfuhr von den Leistungshalbleiterbauelementen zur Kühlflüssigkeit erzielt. Nachteilig hierbei ist, dass die Kühlplatte langfristig und zuverlässig gegen den Kühlkörper abgedichtet sein muss um einen Austritt von Kühlflüssigkeit zuverlässig über die in der Regel lange vorgesehene Nutzungsdauer der Leistungshalbleitereinrichtung zu verhindern.

Es ist Aufgabe der Erfindung eine Leistungshalbleitereinrichtung zu schaffen, die eine gute Wärmeleitung von den Leistungshalbleiterbauelementen zu einem von einem Flüssigkeit durchströmbaren Kühlkörper der Leistungshalbleitereinrichtung aufweist und bei der der Kühlkörper langfristig und zuverlässig dicht ist.

Diese Aufgabe wird gelöst durch eine Leistungshalbleitereinrichtung mit einem Leistungshalbleitermodul und einem von einer Flüssigkeit durchströmbaren Kühlkörper, wobei das Leistungshalbleitermodul Leistungshalbleiterbauelemente, die auf elektrisch leitenden Leiterbahnen angeordnet sind, aufweist, wobei das Leistungshalbleitermodul eine elektrisch nicht leitende Isolationsschicht und eine Kühlplatte aufweist, wobei die Isolationsschicht zwischen den Leiterbahnen und der Kühlplatte angeordnet ist, wobei der Kühlkörper ein erstes Kühlgehäusebauteil, das eine durch das erste Kühlgehäusebauteil hindurchgehende Ausnehmung aufweist und ein zweites Kühlgehäusebauteil aufweist, wobei die Kühlplatte in der Ausnehmung angeordnet ist, wobei das erste und das zweite Kühlgehäusebauteil eine derartige Form aufweisen und derartig zueinander angeordnet sind, dass sich ein Hohlraum an der den Leistungshalbleiterbauelementen abgewandten Seite der Kühlplatte ausbildet, wobei die Kühlplatte mittels einer um die Kühlplatte umlaufenden ersten Schweißnaht mit dem ersten Kühlgehäusebauteil verbunden ist, wobei die erste Schweißnaht die Kühlplatte gegen das erste Kühlgehäusebauteil abdichtet, wobei das zweite Kühlgehäusebauteil mit dem ersten Kühlgehäusebauteil verbunden ist.

Weiterhin wird diese Aufgabe gelöst durch ein Verfahren zur Herstellung einer Leistungshalbleitereinrichtung mit folgenden Verfahrensschritten:
a) Bereitstellen eines Leistungshalbleitermoduls, das Leistungshalbleiterbauelemente, die auf elektrische leitenden Leiterbahnen angeordnet sind, aufweist, wobei das Leistungshalbleitermodul eine elektrisch nicht leitende Isolationsschicht und eine Kühlplatte aufweist, wobei die Isolationsschicht zwischen den Leiterbahnen und der Kühlplatte angeordnet ist und Bereitstellen eines ersten Kühlgehäusebauteils, das eine durch das erste Kühlgehäusebauteil hindurchgehende Ausnehmung aufweist und Bereitstellen eines zweiten Kühlgehäusebauteils,
b) Anordnen der Kühlplatte in der Ausnehmung des ersten Kühlgehäusebauteils,
c) Verschweißen der Kühlplatte mit dem ersten Kühlgehäusebauteil derart, dass eine um die Kühlplatte umlaufende erste Schweißnaht entsteht, die die Kühlplatte gegen das erste Kühlgehäusebauteil abdichtet, wobei das Verschweißen der Kühlplatte mit dem ersten Kühlgehäusebauteil an der den Leistungshalbleiterbauelementen abgewandten Seite der Kühlplatte erfolgt,
d) Anordnen des zweiten Kühlgehäusebauteils zum ersten Kühlgehäusebauteil, wobei das Anordnen des zweiten Kühlgehäusebauteils zum ersten Kühlgehäusebauteils derartig erfolgt und das erste und zweite Kühlgehäusebauteil eine derartige Form aufweisen, dass sich ein Hohlraum an der den Leistungshalbleiterbauelementen abgewandten Seite der Kühlplatte ausbildet und
e) Verbinden des zweiten Kühlgehäusebauteils mit dem ersten Kühlgehäusebauteil.

Vorteilhafte Ausbildungen des Verfahrens ergeben sich analog zu vorteilhaften Ausbildungen der Leistungshalbleitereinrichtung und umgekehrt.

Vorteilhafte Ausbildungen der Erfindung ergeben sich aus den abhängigen Ansprüchen.

Es erweist sich als vorteilhaft, wenn die erste Schweißnaht, die lateralen Seitenflächen der Kühlplatte mit die Ausnehmung begrenzenden lateralen Seitenflächen des ersten Kühlgehäusebauteils verbindet. Hierdurch wird eine zuverlässige Abdichtung des Kühlkörpers gewährleistet.

Weiterhin erweist es sich als vorteilhaft, wenn die erste Schweißnaht hohlraumseitig angeordnet ist. Es sei angemerkt, dass im Sinne der Erfindung unter einer hohlraumseitig angeordneten Schweißnaht eine von Seite des Hohlraums ausgeführte Schweißnaht verstanden wird. Dies hat den großen Vorteil dass der beim Schweißen der ersten Schweißnaht notwenige große Wärmeeintrag an der den Leistungshalbleiterbauelementen abgewandten Seite der Kühlplatte erfolgt und somit nicht auf Seiten der Leistungshalbleiterbauelemente erfolgt, was eine Beschädigung der empfindlichen Leistungshalbleiterbauelemente beim Schweißen der ersten Schweißnaht zuverlässig vermeidet. Die Kühlplatte schützt zudem Leistungshalbleiterschalter und Leiterbahnen vor eventuell sich beim Schweißen ablösenden flüssigen Materials. Die Kühlplatte trennt räumlich zuverlässig den Schweißprozess von den Leistungshalbleiterbauelementen und den Leiterbahnen.

Weiterhin erweist es sich als vorteilhaft, wenn die erste Schweißnaht an einer den Leistungshalbleiterbauelementen zugewandten ersten Außenseite des Kühlkörpers angeordnet ist. Es sei angemerkt, dass im Sinne der Erfindung unter einer an einer den Leistungshalbleiterbauelementen zugewandten ersten Außenseite des Kühlkörpers angeordneten Schweißnaht, eine von Seite der den Leistungshalbleiterbauelementen zugewandten ersten Außenseite des Kühlkörpers ausgeführte Schweißnaht verstanden wird. Eine räumliche Trennung des Schweißprozesses von den Leistungshalbleiterschalter und Leiterbahnen ist in diesem Fall nicht gegeben. Dafür kann das Schweißen der ersten Schweißnaht auch noch nach dem Verbinden des zweite Kühlgehäusebauteils mit dem ersten Kühlgehäusebauteil erfolgen, was eine hohe Flexibilität der Herstellung der Leistungshalbleitereinrichtung ermöglicht.

Weiterhin erweist es sich als vorteilhaft, wenn ein Abschnitt der die Ausnehmung begrenzenden lateralen Seitenflächen des ersten Kühlgehäusebauteils eine zu einem Abschnitt der lateralen Seitenflächen der Kühlplatte korrespondierende Form aufweist. Hierdurch wird ein leichtes und präzises Anordnen der Kühlplatte im ersten Kühlgehäusebauteil ermöglicht, was ein präzises Verschweißen der Kühlplatte und mit dem ersten Kühlgehäusebauteil ermöglicht.

Ferner erweist es sich als vorteilhaft, wenn der Abschnitt der lateralen Seitenflächen der Kühlplatte einen Winkel zu einer den Leistungshalbleiterbauelementen zugewandten Hauptfläche der Kühlplatte von 91° bist 15° oder von 89° bis 65° aufweist und der Abschnitt der die Ausnehmung begrenzenden lateralen Seitenflächen des ersten Kühlgehäusebauteils zu der den Leistungshalbleiterbauelementen zugewandten Hauptfläche der Kühlplatte einen Winkel aufweist, der gleich dem Winkel des Abschnitts der lateralen Seitenflächen der Kühlplatte zu der den Leistungshalbleiterbauelementen zugewandten Hauptfläche der Kühlplatte ist. Hierdurch wird ein leichtes und sehr präzises Anordnen der Kühlplatte im ersten Kühlgehäusebauteil ermöglicht, was ein sehr präzises Verschweißen der Kühlplatte und mit dem ersten Kühlgehäusebauteil ermöglicht.

Weiterhin erweist es sich als vorteilhaft, wenn die Kühlplatte in den Hohlraum hineinreichende Kühlfinnen und/oder Kühlpins aufweist. Hierdurch wird eine sehr gute Wärmeübertragung der Kühlplatte auf die den Kühlkörper durchströmende Flüssigkeit erzielt.

Weiterhin erweist es sich als vorteilhaft, wenn die erste Schweißnaht als Laserschweißnaht, Elektrodenstrahlschweißnaht oder Rührreibschweißnaht ausgebildet ist. Hierdurch wird eine zuverlässige und präzise Verbindung der Kühlplatte mit dem ersten Kühlgehäusebauteil erreicht.

Weiterhin erweist es sich als vorteilhaft, wenn das zweite Kühlgehäusebauteil mittels einer um das zweite Kühlgehäusebauteil umlaufenden zweiten Schweißnaht mit dem ersten Kühlgehäusebauteil verbunden ist, wobei die zweite Schweißnaht das zweite Kühlgehäusebauteil gegen das erste Kühlgehäusebauteil abdichtet. Hierdurch wird eine zuverlässige Verbindung des zweiten Kühlgehäusebauteils mit dem ersten Kühlgehäusebauteil erreicht.

Ferner erweist es sich als vorteilhaft, wenn das erste Kühlgehäusebauteil das zweite Kühlgehäusebauteil lateral umschließt, wobei die zweite Schweißnaht, die lateralen Seitenflächen des zweiten Kühlgehäusebauteils mit innenliegenden lateralen Seitenflächen des ersten Kühlgehäusebauteils verbindet. Hierdurch wird eine zuverlässige Verbindung des zweiten Kühlgehäusebauteils mit dem ersten Kühlgehäusebauteil erreicht.

Ferner erweist es sich als vorteilhaft, wenn die zweite Schweißnaht an einer den Leistungshalbleiterbauelementen abgewandten zweiten Außenseite des Kühlkörpers angeordnet ist. Es sei angemerkt, dass im Sinne der Erfindung unter einer an einer den Leistungshalbleiterbauelementen abgewandten zweiten Außenseite des Kühlkörpers angeordneten Schweißnaht, eine von Seite der den Leistungshalbleiterbauelementen abgewandten zweiten Außenseite des Kühlkörpers ausgeführte Schweißnaht verstanden wird. Hierdurch wird ein einfaches Verschweißen des ersten und zweiten Kühlkörpers von Außen ermöglicht.

Weiterhin erweist es sich als vorteilhaft, wenn das zweite Kühlgehäusebauteil einen vom ersten Kühlgehäusebauteil wegstehenden Bauch aufweist, wobei die zweite Schweißnaht, die lateralen Seitenflächen des zweiten Kühlgehäusebauteils mit einer den Leistungshalbleiterbauelementen abgewandten ersten Hauptfläche des ersten Kühlgehäusebauteils verbindet. Hierdurch wird eine zuverlässige Verbindung des zweiten Kühlgehäusebauteils mit dem ersten Kühlgehäusebauteil erreicht.

Weiterhin erweist es sich als vorteilhaft, wenn die zweite Schweißnaht als Laserschweißnaht, Elektrodenstrahlschweißnaht oder Rührreibschweißnaht ausgebildet ist. Hierdurch wird eine zuverlässige und präzise Verbindung des zweiten Kühlgehäusebauteils mit dem ersten Kühlgehäusebauteil erreicht.

Weiterhin erweist es sich als vorteilhaft, wenn der an die erste Schweißnaht angrenzende Seitenflächenbereich der Kühlplatte und der an die erste Schweißnaht angrenzende Seitenflächenbereich des ersten Kühlgehäusebauteils zueinander bündig angeordnet sind. Hierdurch wird eine besonders zuverlässige und präzise Verbindung der Kühlplatte mit dem ersten Kühlgehäusebauteil erreicht. Der an die erste Schweißnaht angrenzende Seitenflächenbereich der Kühlplatte und der an die erste Schweißnaht angrenzende Seitenflächenbereich des ersten Kühlgehäusebauteils verlaufen vorzugsweise parallel zur Isolationsschicht.

Ausführungsbeispiele der Erfindung sind in den Figuren dargestellt und werden im Folgenden näher erläutert. Dabei zeigen:
- FIG 1: eine perspektivische Vorderansicht einer erfindungsgemäßen Leistungshalbleitereinrichtung,
- FIG 2: eine Schnittansicht einer erfindungsgemäßen Leistungshalbleitereinrichtung,
- FIG 3: eine perspektivische Rückansicht eines ersten Kühlgehäusebauteils in das eine Kühlplatte eingeschweißt ist,
- FIG 4: eine perspektivische Rückansicht einer erfindungsgemäßen Leistungshalbleitereinrichtung,

- FIG 5: eine perspektivische Vorderansicht einer erfindungsgemäßen Leistungshalbleitereinrichtung in einem noch nicht montierten Zustand,
- FIG 6: eine Schnittansicht einer Ausbildungsvariante einer erfindungsgemäßen Leistungshalbleitereinrichtung ,
- FIG 7: eine perspektivische Vorderansicht einer weiteren erfindungsgemäßen Leistungshalbleitereinrichtung,
- FIG 8: eine Schnittansicht einer weiteren erfindungsgemäßen Leistungshalbleitereinrichtung,
- FIG 9: eine perspektivische Rückansicht eines ersten Kühlgehäusebauteils in das eine Kühlplatte eingeschweißt ist,
- FIG 10: eine perspektivische Rückansicht einer weiteren erfindungsgemäßen Leistungshalbleitereinrichtung und
- FIG 11: eine perspektivische Vorderansicht einer weiteren erfindungsgemäßen Leistungshalbleitereinrichtung in einem noch nicht montierten Zustand.

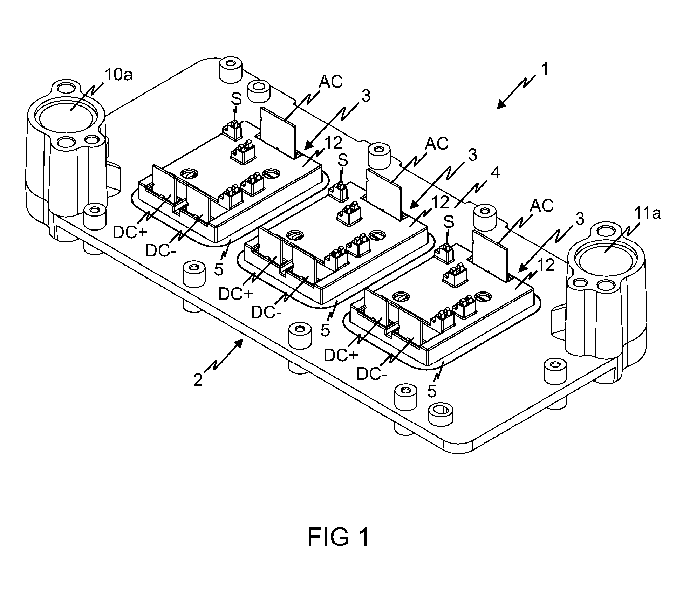

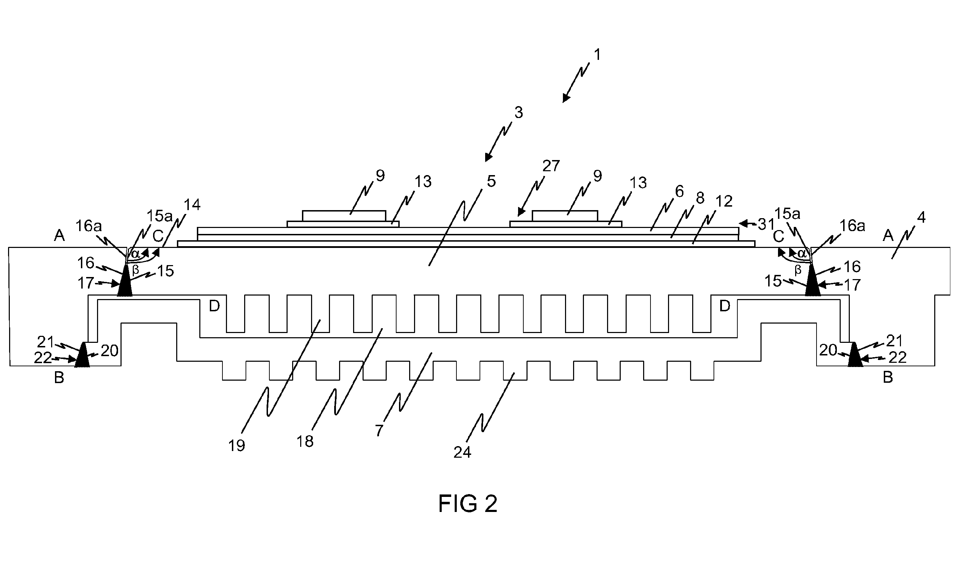

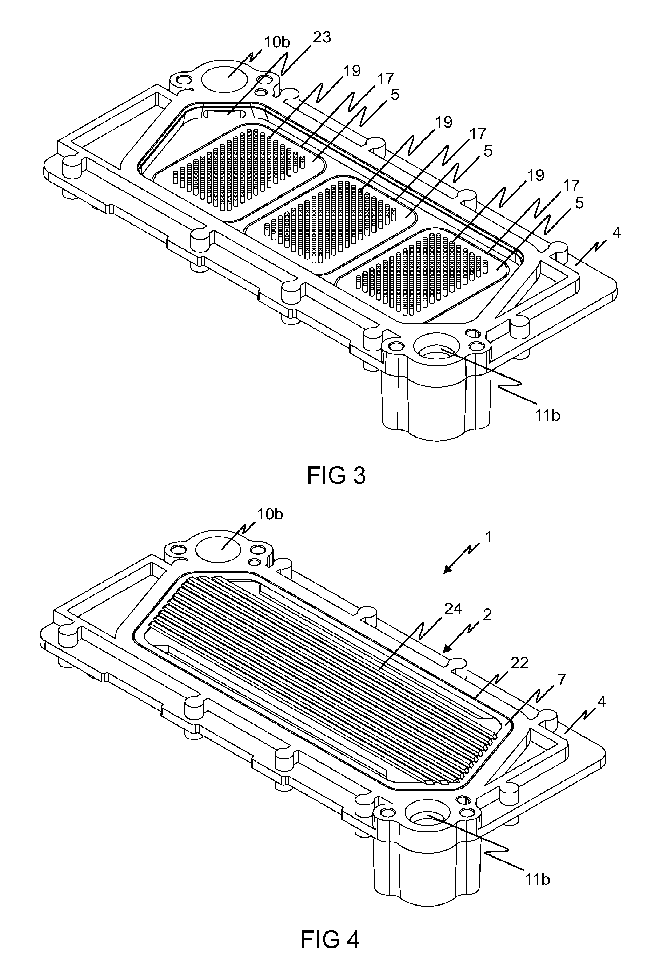

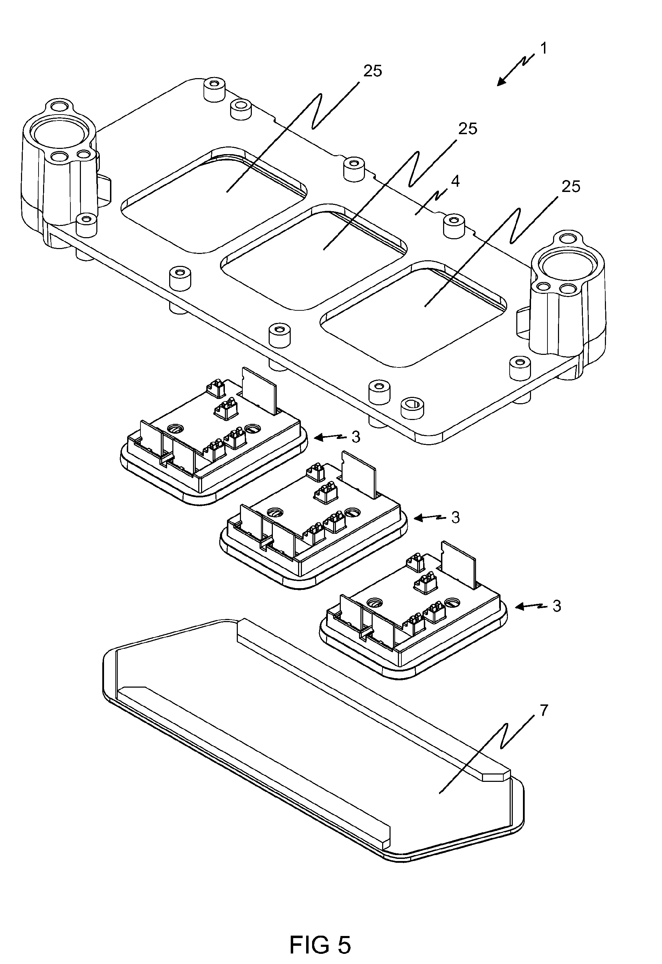

In FIG 1, FIG 2 und FIG 4 ist eine erfindungsgemäße Leistungshalbleitereinrichtung 1 dargestellt, wobei in FIG 2 und den übrigen Schnittansichten nur die zum Verständnis der Erfindung wesentlichen Elemente der Leistungshalbleitereinrichtung 1 dargestellt sind. In FIG 3 ist eine perspektivische Rückansicht eines ersten Kühlgehäusebauteils 4 in das eine Kühlplatte 5 eingeschweißt ist, dargestellt. In FIG 5 ist eine perspektivische Vorderansicht der erfindungsgemäßen Leistungshalbleitereinrichtung 1 in einem noch nicht montierten Zustand dargestellt. Die erfindungsgemäße Leistungshalbleitereinrichtung weist mindestens ein Leistungshalbleitermodul 3 auf, wobei die erfindungsgemäße Leistungshalbleitereinrichtung eine Vielzahl von Leistungshalbleitermodulen 3 aufweisen kann und beim Ausführungsbeispiel drei Leistungshalbleitermodule 3 aufweist. Das jeweilige Leistungshalbleitermodul 3 weist Leistungshalbleiterbauelemente 9, die auf elektrisch leitenden Leiterbahnen 13 angeordnet sind, auf. Die Leiterbahnen 13 werden durch eine elektrisch leitende strukturierte erste Leitungsschicht 31 ausgebildet. Die Leistungshalbleiterbauelemente 9 sind mit den Leiterbahnen 13, vorzugsweise über eine Löt- oder Sintermetallschicht, elektrisch leitend verbunden. Das jeweilige Leistungshalbleiterbauelement liegt vorzugweise in Form eines Leistungshalbleiterschalters oder einer Diode vor. Die Leistungshalbleiterschalter liegen dabei vorzusgweise in Form von Transistoren, wie z.B. IGBTs (Insulated Gate Bipolar Transistor) oder MOSFETs (Metal Oxide Semiconductor Field Effect Transistor) vor. Das jeweilige Leistungshalbleitermodul 3 weist vorzugsweise ein erstes Gleichspannungslaststromanschlusselement DC+ und einen zweites Gleichspannungslaststromanschlusselement DC- und ein Wechselstromlastanschlusselement AC auf, die mit der ersten Leitungsschicht 31 vorzugsweise über eine Löt- oder Sintermetallschicht, elektrisch leitend verbunden sind. Im Rahmen des dargestellten Ausführungsbeispiels erzeugt das jeweilige Leistungshalbleitermodul 3 aus einer zwischen den Gleichspannungslaststromanschlüssen DC+ und DC- eingespeisten Gleichspannung am Wechselspannungslaststromanschluss AC eine Wechselspannung. Weiterhin weist das jeweilige Leistungshalbleitermodul 3 im Rahmen des Ausführungsbeispiels Steueranschlusselemente S auf, die elektrisch leitend mit den Steueranschlüssen der Leistungshalbleiterschalter des Leistungshalbleitermoduls 3 verbunden sind.

Weiterhin weist das jeweilige Leistungshalbleitermodul 3 eine elektrisch nicht leitende Isolationsschicht 6 und eine Kühlplatte 5 auf, wobei die Isolationsschicht 6 zwischen den Leiterbahnen 13 und der Kühlplatte 5 angeordnet ist. Die Leiterbahnen 13 sind mit der Isolationsschicht 6 verbunden. Im Rahmen des Ausführungsbeispiels ist zwischen der Isolationsschicht 6 und der Kühlplatte 5 eine elektrisch leitende vorzugweise unstrukturierte zweite Leitungsschicht 8 angeordnet, die mit der Isolationsschicht 6 verbunden ist. Die Isolationsschicht 6 liegt vorzugsweise in Form eines Keramikkörpers vor. Die erste und zweite Leitungsschicht 31 und 8 und die Isolationsschicht 6 werden zusammen vorzugsweise durch ein Direct Copper Bonded Substrat (DCB-Substrat) ausgebildet.

Es sei an dieser Stelle angemerkt, dass die erste und die zweite Leitungsschicht aus einer einzelnen Schicht oder auch mehreren übereinanderliegenden Schichten bestehen können. So kann die erste und/oder die zweite Leitungsschicht z.B. eine Kupferschicht aufweisen, die eine einzelne oder mehrere übereinanderliegende Beschichtungen, z.B. aus einem Edelmetall (z.B. Silber) oder aus einer Edelmetallverbindung aufweist, welche z.B. als Haftvermittlungsschichten und/oder Schutzschichten dienen können.

Die Kühlplatte 5 besteht vorzugsweise aus Aluminium (z.B. Al 99,5) und kann an Ihrer den Leistungshalbleiterbauelementen 9 zugewandten Seite C mit einer einzelnen oder mehreren übereinanderliegende Schichten beschichtet sein, die z.B. jeweilig als Haftvermittlungsschicht und/oder als Schutzschicht dienen können und/oder dazu dienen können mechanische Spannungen zwischen Isolationsschicht 6 und der Kühlplatte 5, welche bei Temperaturänderungen, aufgrund unterschiedlicher Temperaturausdehnungskoeffizienten von Isolationsschicht 6 und Kühlplatte 5, auftreten können, zu reduzieren. Im Rahmen des Ausführungsbeispiels ist die Kühlplatte 5 an Ihrer der Isolationsschicht 6 zugewandten Seite C mit einer Kupferschicht 12 beschichtet, die wiederum z.B. mit einer Beschichtung, insbesondere einer Edelmetallbeschichtung (z.B. Silber) beschichtet sein kann. Die Kupferschicht 12 ist zwischen Kühlplatte 5 und Isolationsschicht 6, und insbesondere zwischen Kühlplatte und zweiter Leitungsschicht 8 angeordnet. Die zweite Leitungsschicht 8 ist mit der Kühlplatte 5, vorzugsweise über eine Löt- oder Sintermetallschicht, direkt oder indirekt (falls die Kühlplatte an Ihrer den Leistungshalbleiterbauelementen zugewandten Seite mit einer einzelnen oder mehreren übereinanderliegenden Schichten beschichtet ist) verbunden. Die zweiter Leitungsschicht 8 ist im Rahmen des Ausführungsbeispiels über eine Löt- oder Sintermetallschicht mit der Kupferschicht 12 verbunden.

Der Übersichtlichkeit halber sind in FIG 2 die Löt- oder Sintermetallschichten nicht dargestellt. Weiterhin sei angemerkt, dass die Dicke der Schichten und die Dicke der Leistungshalbleiterbauelemente nicht maßstabsgerecht dargestellt sind.

Es sei an dieser Stelle angemerkt, dass die Kühlplatte auch in Form eines Aluminiumkörpers eines Insulated Metal Substrats (IMS) vorliegen kann.

Die Kühlplatte 5 weist vorzugsweise an ihrer den Leitungshalbleiterbauelementen 9 abgewandten Seite D Kühlfinnen und/oder Kühlpins 19 auf.

Weiterhin weist die Leistungshalbleitereinrichtung 1 einen von einer Flüssigkeit durchströmbaren Kühlkörper 2 auf, der ein erstes Kühlgehäusebauteil 4 und ein zweites Kühlgehäusebauteil 7 aufweist. Das erste Kühlgehäusebauteil 4 weist für das jeweilige Leistungshalbleitermodule 3 ein durch das erste Kühlgehäusebauteil 4 hindurchgehende jeweilige Ausnehmung 25 (siehe FIG 5) auf, wobei die Kühlplatte 5 des jeweiligen Leistungshalbleitermoduls 3 in der jeweiligen Ausnehmung 25 angeordnet ist. Ein Teil der jeweiligen Kühlplatte 25 kann dabei aus der jeweiligen Ausnehmung 25 herausragen. Die jeweilige Kühlplatte 5 verschließt die jeweilige Ausnehmung 25. Das erste und das zweite Kühlgehäusebauteil 4 und 7 weisen eine derartige Form aufweisen und sind derartig zueinander angeordnet, dass sich ein Hohlraum 18 an der den Leistungshalbleiterbauelementen 9 abgewandten Seite D der Kühlplatte 5 ausbildet. Das zweite Kühlgehäusebauteil 7 ist mit dem ersten Kühlgehäusebauteil 4 verbunden. Die Flüssigkeit durchströmt den Kühlkörper 2, indem sie den Hohlraum 18 durchströmt. Die Wärme der Kühlplatte 5 wird auf die Flüssigkeit übertragen und von der Flüssigkeit abtransportiert.

Im Folgenden wird die Anordnung der Leistungshalbleitermodule 3 und die Verbindung der Leistungshalbleitermodule 3 mit dem ersten Kühlgehäusebauteil 4 anhand eines der Leistungshalbleitermodule 3 beschrieben, wobei die anderen Leistungshalbleitermodule 3 in analoger Weise angeordnet und mit dem ersten Kühlgehäusebauteil 4 verbunden sind.

Die Kühlplatte 5 des Leistungshalbleitermoduls 3 ist mittels einer um die Kühlplatte 5 umlaufenden ersten Schweißnaht 17 mit dem ersten Kühlgehäusebauteil 4 verbunden, wobei die erste Schweißnaht 17 die Kühlplatte 5 gegen das erste Kühlgehäusebauteil 4 abdichtet. Die erste Schweißnaht 17 verläuft geschlossen umlaufend um die Kühlplatte 5.

Die erste Schweißnaht 17 verbindet dabei vorzugsweise die lateralen Seitenflächen 15 der Kühlplatte 5 mit den die Ausnehmung 25 begrenzenden lateralen Seitenflächen 16 des ersten Kühlgehäusebauteils 4.

Die erste Schweißnaht 17 ist vorzugsweise ausschließlich hohlraumseitig, d.h. ausschließlich auf Seite des Hohlraums 18 angeordnet. Die erste Schweißnaht 17 ist vorzugsweise ausschließlich an der den Leistungshalbleiterbauelementen abgewandten Seite D der Kühlplatte 5 angeordnet. Die erste Schweißnaht 17 verläuft solchermaßen nicht vollständig von der Seite des Hohlraums 18 zu der den Leistungshalbleiterbauelementen 9 zugewandten ersten Außenseite A des Kühlkörpers 2 hindurch. Dies hat den großen Vorteil dass der beim Schweißen der ersten Schweißnaht 17 notwenige große Wärmeeintrag an der den Leistungshalbleiterbauelementen 9 abgewandten Seite D der Kühlplatte 5 erfolgt und somit nicht auf der Seite der Leistungshalbleiterbauelemente 9 erfolgt, was eine Beschädigung der empfindlichen Leistungshalbleiterbauelemente 9 beim Schweißen der ersten Schweißnaht zuverlässig vermeidet. Die Kühlplatte 5 schützt zudem die Leistungshalbleiterschalter 9 und Leiterbahnen 13 vor eventuell sich beim Schweißen ablösenden flüssigen Material. Die Kühlplatte 5 trennt somit räumlich zuverlässig den Schweißprozess von den Leistungshalbleiterbauelementen und Leiterbahnen. Weiterhin ist bei einer hohlraumseitigen Anordnung der ersten Schweißnaht sichergestellt, dass zwischen Kühlplatte und erstem Kühlgehäusebauteil kein Spalt verbleibt in den Flüssigkeit aus dem Hohlraum 18 eindringen kann, was da diese Flüssigkeit ruhend im Spalt verbleiben würde, zu einer Korrosion der Kühlplatte oder des ersten Kühlgehäusebauteils führen kann.

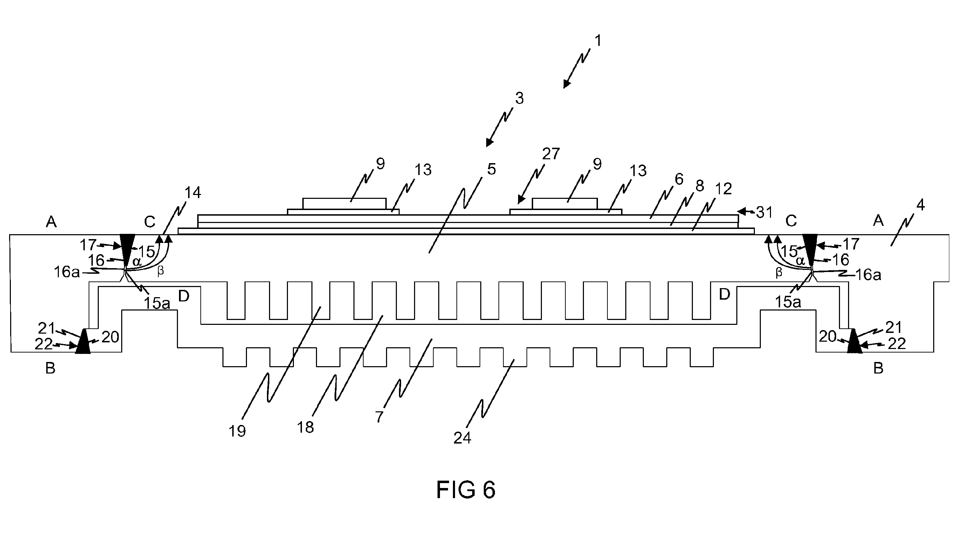

Alternativ hierzu kann, wie in FIG 6 dargestellt, die erste Schweißnaht 17 auch ausschließlich an einer den Leistungshalbleiterbauelementen zugewandten ersten Außenseite A des Kühlkörpers 2 angeordnet sein. Die erste Schweißnaht 17 ist in diesem Fall ausschließlich an der den Leistungshalbleiterbauelementen 9 zugewandten Seite C der Kühlplatte 5 angeordnet. Die erste Schweißnaht 17 verläuft solchermaßen nicht vollständig von der den Leistungshalbleiterbauelementen 9 zugewandten ersten Außenseite A des Kühlkörpers 2 zur Seite des Hohlraums 18 hindurch. Eine räumliche Trennung des Schweißprozesses von den Leistungshalbleiterschaltern 9 und Leiterbahnen 13 ist in diesem Fall nicht gegeben. Dafür kann das Schweißen der ersten Schweißnaht auch noch nach dem Verbinden des zweiten Kühlgehäusebauteils 7 mit dem ersten Kühlgehäusebauteil 4 erfolgen, was eine hohe Flexibilität der Herstellung der Leistungshalbleitereinrichtung 1 ermöglicht.

Vorzugsweise weist ein Abschnitt 16a der die Ausnehmung 25 begrenzenden lateralen Seitenflächen 16 des ersten Kühlgehäusebauteils 4 eine zu einem Abschnitt 15a der lateralen Seitenflächen 15 der Kühlplatte 5 korrespondierende Form auf. Hierzu weist vorzugsweise der Abschnitt 15a der lateralen Seitenflächen 15 der Kühlplatte 5 einen Winkel α zu einer den Leistungshalbleiterbauelementen 9 zugewandten Hauptfläche 14 der Kühlplatte 5 von 91 °bis 115° oder von 89° bis 65° auf und der Abschnitt 16a der die Ausnehmung 25 begrenzenden lateralen Seitenflächen 16 des ersten Kühlgehäusebauteils 4 weist zu der den Leistungshalbleiterbauelementen 9 zugewandten Hauptfläche 14 der Kühlplatte 5 einen Winkel β auf, der gleich dem Winkel α des Abschnitts 15a der lateralen Seitenflächen 15 der Kühlplatte 5 zu der den Leistungshalbleiterbauelementen 9 zugewandten Hauptfläche 14 der Kühlplatte 5 ist. Zwischen dem Abschnitt 15a der lateralen Seitenflächen 15 der Kühlplatte 5 und dem Abschnitt 16a der die Ausnehmung 25 begrenzenden lateralen Seitenflächen 16 des ersten Kühlgehäusebauteils 4 ist vorzugsweise ein Spalt ausgebildet.

Alternativ hierzu kann z.B. ein Abschnitt der lateralen Seitenflächen der Kühlplatte auch eine erste stufenförmige Form aufweisen und ein Abschnitt der die Ausnehmung begrenzenden lateralen Seitenflächen des ersten Kühlgehäusebauteils eine zur ersten stufenförmigen Form korrespondierende zweite stufenförmige Form aufweisen.

Das Schweißen der ersten Schweißnaht 17 erfolgt vorzugsweise mittels eines Lasers, so dass die erste Schweißnaht 17 vorzugsweise als eine Laserschweißnaht ausgebildet ist. Alternativ kann das Schweißen der ersten Schweißnaht 17 z.B. auch mittels Elektrodenstrahlschweißen erfolgen, so dass die erste Schweißnaht 17 als Elektrodenstrahlschweißnaht ausgebildet sein kann. Weiterhin kann alternativ das Schweißen der ersten Schweißnaht 17 z.B. auch mittels Rührreibschweißen erfolgen, so dass die erste Schweißnaht 17 als Rührreibschweißnaht ausgebildet sein kann. Selbstverständlich sind auch andere Schweißverfahren zur Ausbildung der ersten Schweißnaht möglich.

Die Kühlplatte 5 weist vorzugsweise in den Hohlraum 18 hineinreichende Kühlfinnen und/oder Kühlpins 19 auf.

Vorzugsweise ist das zweite Kühlgehäusebauteil 7 mittels einer um das zweite Kühlgehäusebauteil 7 umlaufenden zweiten Schweißnaht 22 mit dem ersten Kühlgehäusebauteil 4 verbunden ist, wobei die zweite Schweißnaht 22 das zweite Kühlgehäusebauteil 7 gegen das erste Kühlgehäusebauteil 5 abdichtet. Die zweite Schweißnaht 22 verläuft geschlossen umlaufend um das zweite Kühlgehäusebauteil 7.

Im Rahmen des Ausführungsbeispiels gemäß der Figuren 1 bis 6 umschließt das erste Kühlgehäusebauteil 4 das zweite Kühlgehäusebauteil 7 lateral, wobei die zweite Schweißnaht 22, die lateralen Seitenflächen 20 des zweiten Kühlgehäusebauteils 7 mit innenliegenden lateralen Seitenflächen 21 des ersten Kühlgehäusebauteils 4 verbindet. Das erste Kühlgehäusebauteil 4 bildet die lateralen Außenwände des Kühlkörpers 2 aus. Die zweite Schweißnaht 22 ist an einer den Leistungshalbleiterbauelementen 9 abgewandten zweiten Außenseite B des Kühlkörpers 2 angeordnet. Die zweite Schweißnaht 22 ist solchermaßen an der den Leistungshalbleiterbauelementen 9 zugwandten ersten Außenseite A des Kühlkörpers gegenüberliegenden zweiten Außenseite B des Kühlkörpers angeordnet.

Das Schweißen der zweiten Schweißnaht 22 erfolgt vorzugsweise mittels eines Lasers, so dass die zweite Schweißnaht 22 vorzugsweise als eine Laserschweißnaht ausgebildet ist. Alternativ kann das Schweißen der zweiten Schweißnaht 22 z.B. auch mittels Elektrodenstrahlschweißen erfolgen, so dass die zweite Schweißnaht 22 als Elektrodenstrahlschweißnaht ausgebildet sein kann. Weiterhin kann alternativ das Schweißen der zweiten Schweißnaht 22 z.B. auch mittels Rührreibschweißen erfolgen, so dass die zweite Schweißnaht 22 als Rührreibschweißnaht ausgebildet sein kann. Selbstverständlich sind auch andere Schweißverfahren zur Ausbildung der zweiten Schweißnaht möglich.

Das zweite Kühlgehäusebauteil 7 weist vorzugsweise an seiner den Leitungshalbleiterbauelementen 9 abgewandten Seite Kühlfinnen und/oder Kühlpins 24 auf.

Der Kühlkörper 2 weist weiterhin vorzugsweise eine Flüssigkeitsvorlaufeintrittsöffnung 10a und eine zur Flüssigkeitsvorlaufeintrittsöffnung 10a fluchtend angeordnete Flüssigkeitsvorlaufaustrittsöffnung 10b, sowie eine Flüssigkeitsrücklaufeintrittsöffnung 11a und eine zur Flüssigkeitsrücklaufeintrittsöffnung 11a fluchtend angeordnete Flüssigkeitsrücklaufaustrittsöffnung 11 b auf. Im Betrieb der Leistungshalbleitereinrichtung 1 fließt die Flüssigkeit (z.B. Wasser) zur Kühlung der Leistungshalbleiterbauelemente 9 in die Flüssigkeitsvorlaufeintrittsöffnung 10a des Kühlkörpers 2 hinein. Ein Teil der Flüssigkeit fließt durch die Flüssigkeitsvorlaufaustrittsöffnung 10b wieder aus dem Kühlerkörper 2 und ein anderer Teil fließt durch den Kühlkörper 2 und insbesondere durch den Hohlraum 18 hindurch und fließt an der Flüssigkeitsrücklaufaustrittsöffnung 11 b wieder aus dem Kühlkörper 2 heraus. Das Ein- und Ausfließen der Flüssigkeit in und aus dem Hohlraum 18 erfolgt über Kanäle, wobei in FIG 3 nur ein Kanal 23 sichtbar ist. Die Anordnung der Flüssigkeitsvorlaufeintrittsöffnung 10a, der Flüssigkeitsvorlaufaustrittsöffnung 10b, der Flüssigkeitsrücklaufeintrittsöffnung 11a und der Flüssigkeitsrücklaufaustrittsöffnung 11 b erlaubt das hintereinander Anordnen von mehreren Kühlkörpern 2 bzw. mehren erfindungsgemäßen Leistungshalbleitereinrichtungen 1 zu einem Leistungshalbleitereinrichtungssystem, wobei die jeweilig zugehörigen Flüssigkeitsöffnungen der Kühlkörper miteinander verbunden werden.

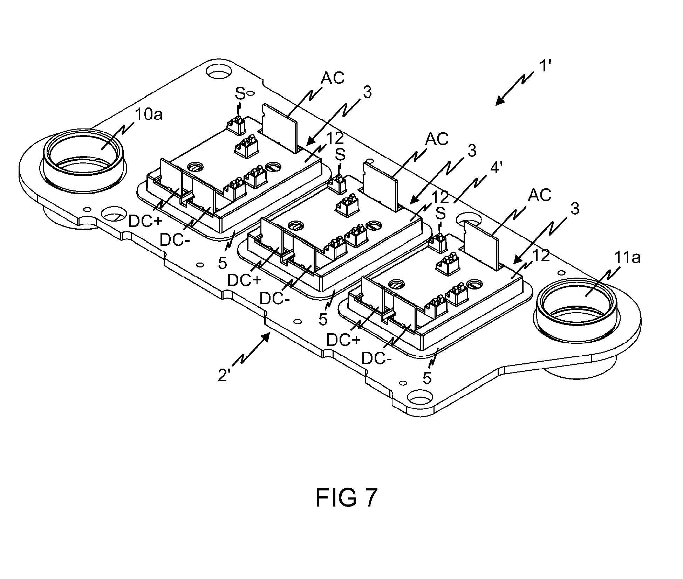

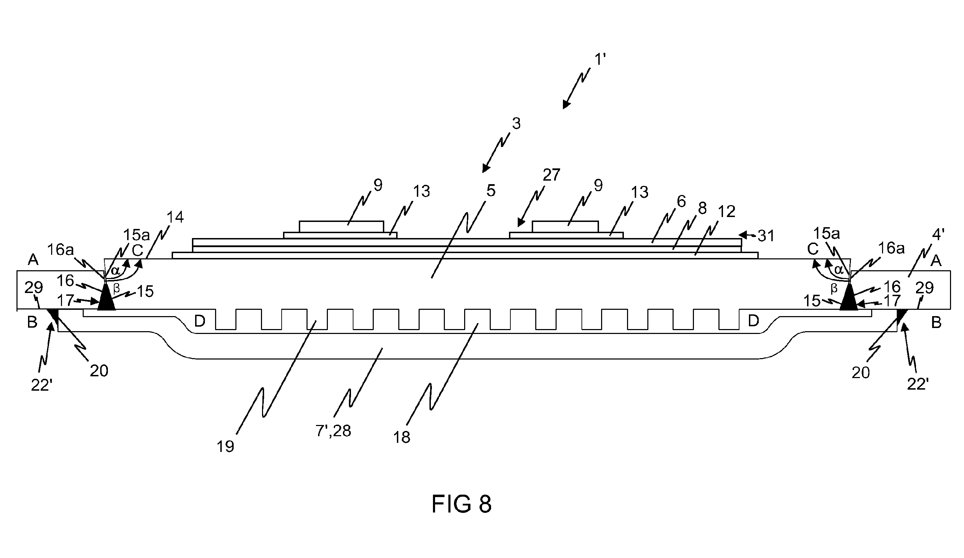

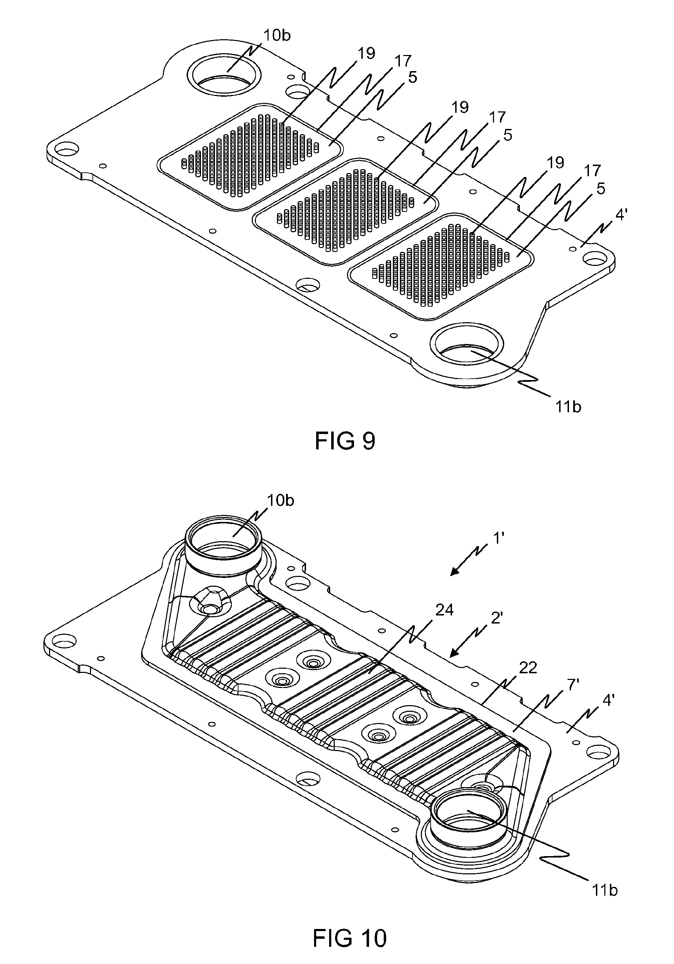

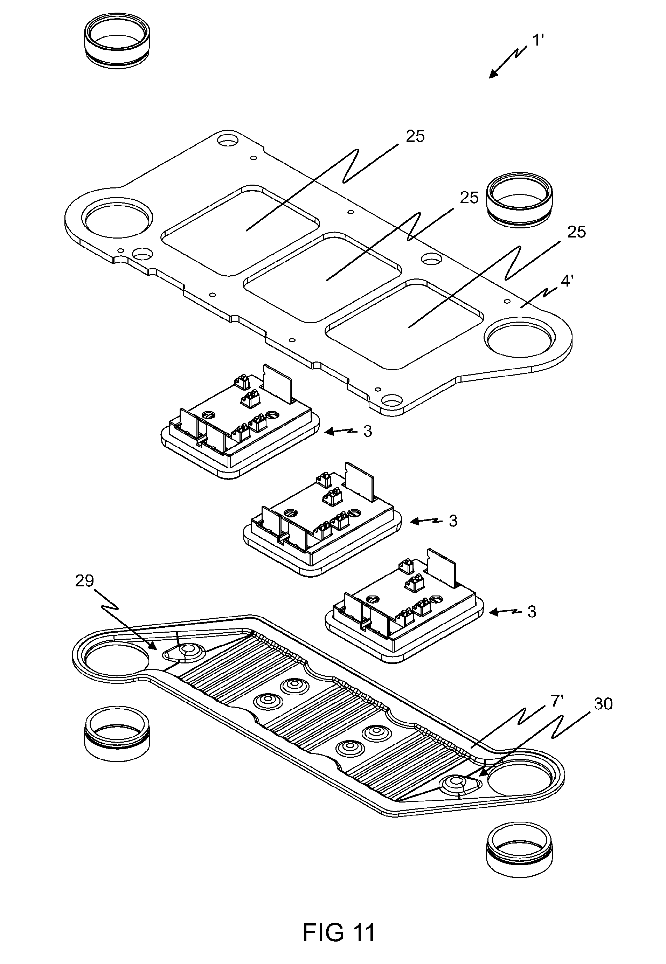

In FIG 7, FIG 8 und FIG 10 ist eine weitere erfindungsgemäße Leistungshalbleitereinrichtung 1' dargestellt, wobei in FIG 8 nur die zum Verständnis der Erfindung wesentlichen Elemente der Leistungshalbleitereinrichtung 1' dargestellt sind. In FIG 9 ist eine perspektivische Rückansicht eines ersten Kühlgehäusebauteils 4' in das eine Kühlplatte 5 eingeschweißt ist, dargestellt. In FIG 11 ist die Leistungshalbleitereinrichtung 1' in einem noch nicht montierten Zustand dargestellt. Die Leistungshalbleitereinrichtung 1' ist dabei analog der Leistungshalbleitereinrichtung 1 aufgebaut, wobei das erste und zweite Kühlgehäusebauteil 4' und 7' gegenüber dem ersten und zweiten Kühlgehäusebauteil 4 und 7 der Leistungshalbleitereinrichtung 1 modifiziert ausgebildet sind. Gleiche Elemente sind dabei in FIG 7 bis FIG 11 mit den gleichen Bezugszeichen versehen wie in FIG 1 bis FIG 6. Bei der Leistungshalbleitereinrichtung 1' weist das zweite Kühlgehäusebauteil 7' einen vom ersten Kühlgehäusebauteil 4' wegstehenden Bauch 28 auf, wobei die zweite Schweißnaht 22', die lateralen Seitenflächen 20 des zweiten Kühlbauteils 7' mit einer den Leistungshalbleiterbauelementen 9 abgewandten ersten Hauptfläche 29 des ersten Kühlbauteils 4' verbindet. Das erste Kühlgehäusebauteil 4' umschließt nicht lateral das zweite Kühlgehäusebauteil 7'. Das zweite Kühlgehäusebauteil 7' ist in Richtung weg von den Leistungshalbleiterbauelementen 9 neben dem ersten Kühlgehäusebauteil 4' angeordnet.

Es sei an dieser Stelle angemerkt, dass das erste Kühlgehäusebauteil vorzugsweise aus Aluminium (z.B. AL 99,5) oder vorzugsweise aus einer Aluminiumlegierung, wie z.B. AlSi10Mg-F oder AlMg4,5Mn, besteht. Weiterhin sei angemerkt, dass das zweite Kühlgehäusebauteil vorzugsweise aus Aluminium (z.B. AL 99,5) oder vorzugsweise aus einer Aluminiumlegierung, wie z.B. AlSi10Mg-F oder AlMg4,5Mn, besteht. Vorzugsweise sollte das Aluminium oder die Aluminiumlegierung zumindest im Bereich der jeweiligen Schweißnaht porenarm oder porenfrei sein. Das erste und/oder zweite Kühlgehäusebauteil kann jeweilig z.B. in Form eines gegossenen Bauteils oder z.B. in Form eines Tiefziehbauteils vorliegen.

Ferner sei angemerkt, dass das erste und zweite Kühlgehäusebauteil jeweilig einstückig ausgebildet sein können oder jeweilig aus miteinander verbundenen Stücken ausgebildet sein können.

Weiterhin sei angemerkt, dass vorzugsweise der an die erste Schweißnaht angrenzende Seitenflächenbereich der Kühlplatte und der an die erste Schweißnaht angrenzende Seitenflächenbereich des ersten Kühlgehäusebauteils zueinander bündig angeordnet sind. Der an die erste Schweißnaht angrenzende Seitenflächenbereich der Kühlplatte und der an die erste Schweißnaht angrenzende Seitenflächenbereich des ersten Kühlgehäusebauteils verlaufen vorzugsweise parallel zur Isolationsschicht.

Weiterhin sei angemerkt, dass selbstverständlich Merkmale von verschiedenen Ausführungsbeispielen der Erfindung, sofern sich die Merkmale nicht gegenseitig ausschließen, beliebig miteinander kombiniert werden können.

Im Folgenden wird ein Verfahren zur Herstellung einer erfindungsgemäßen Leistungshalbleitereinrichtung 1 bzw. 1' angegeben.

In einem ersten Verfahrensschritt erfolgt ein Bereitstellen eines Leistungshalbleitermoduls 3, das Leistungshalbleiterbauelemente 9, die auf elektrische leitenden Leiterbahnen 13 angeordnet sind, aufweist, wobei das Leistungshalbleitermodul 3 eine elektrisch nicht leitende Isolationsschicht 6 und eine Kühlplatte 5 aufweist, wobei die Isolationsschicht 9 zwischen den Leiterbahnen 13 und der Kühlplatte 5 angeordnet ist und ein Bereitstellen eines ersten Kühlgehäusebauteils 4 bzw. 4', das eine durch das erste Kühlgehäusebauteil 4 bzw. 4' hindurchgehende Ausnehmung 25 aufweist und ein Bereitstellen eines zweiten Kühlgehäusebauteils 7 bzw. 7'.

In einem weiteren Verfahrensschritt erfolgt ein Anordnen der Kühlplatte 5 in der Ausnehmung 25 des ersten Kühlgehäusebauteils 4 bzw. 4'.

In einem weiteren Verfahrensschritt erfolgt ein Verschweißen der Kühlplatte 5 mit dem ersten Kühlgehäusebauteil 4 bzw. 4' derart, dass eine um die Kühlplatte 5 umlaufende erste Schweißnaht 17 entsteht, die die Kühlplatte 5 gegen das erste Kühlgehäusebauteil 4 bzw. 4' abdichtet, wobei das Verschweißen der Kühlplatte 5 mit dem ersten Kühlgehäusebauteil 4 bzw. 4' an der den Leistungshalbleiterbauelementen 9 abgewandten Seite D der Kühlplatte 5 erfolgt.

In einem weiteren Verfahrensschritt erfolgt ein Anordnen des zweiten Kühlgehäusebauteils 7 bzw. 7' zum ersten Kühlgehäusebauteil 4 bzw. 4', wobei das Anordnen des zweiten Kühlgehäusebauteils 7 bzw. 7' zum ersten Kühlgehäusebauteils 4 bzw. 4' derartig erfolgt und das erste und zweite Kühlgehäusebauteil eine derartige Form aufweisen, dass sich ein Hohlraum 18 an der den Leistungshalbleiterbauelementen 9 abgewandten Seite D der Kühlplatte 5 ausbildet.

In einem weiteren Verfahrensschritt erfolgt ein Verbinden des zweiten Kühlgehäusebauteils 7 bzw. 7' mit dem ersten Kühlgehäusebauteil 4 bzw. 4' Vorzugsweise erfolgt das Verbinden des zweiten Kühlgehäusebauteils 7 bzw. 7' mit dem ersten Kühlgehäusebauteil 4 bzw. 4' durch Verschweißen des zweiten Kühlgehäusebauteils 7 bzw. 7' mit dem ersten Kühlgehäusebauteil 4 bzw. 4', wobei das Verschweißen des zweiten Kühlgehäusebauteils 7 bzw. 7' mit dem ersten Kühlgehäusebauteil 4 bzw. 4' derartig durchgeführt wird, dass das zweite Kühlgehäusebauteil 7 bzw. 7' mittels einer um das zweite Kühlgehäusebauteil 7 bzw. 7' umlaufenden zweiten Schweißnaht 22 bzw. 22' mit dem ersten Kühlgehäusebauteil 4 bzw. 4' verbunden wird, wobei die zweite Schweißnaht 22 bzw. 22' das zweite Kühlgehäusebauteil 7 bzw. 7' gegen das erste Kühlgehäusebauteil 4 bzw. 4' abdichtet.

## Patentansprüche

1. Leistungshalbleitereinrichtung mit einem Leistungshalbleitermodul (3) und einem von einer Flüssigkeit durchströmbaren Kühlkörper (2), wobei das Leistungshalbleitermodul (3) Leistungshalbleiterbauelemente (9), die auf elektrisch leitenden Leiterbahnen (13) angeordnet sind, aufweist, wobei das Leistungshalbleitermodul (3) eine elektrisch nicht leitende Isolationsschicht (6) und eine Kühlplatte (5) aufweist, wobei die Isolationsschicht (6) zwischen den Leiterbahnen (9) und der Kühlplatte (5) angeordnet ist, wobei der Kühlkörper (2) ein erstes Kühlgehäusebauteil (4,4'), das eine durch das erste Kühlgehäusebauteil (4,4') hindurchgehende Ausnehmung (25) aufweist und ein zweites Kühlgehäusebauteil (7,7') aufweist, wobei die Kühlplatte (5) in der Ausnehmung (25) angeordnet ist, wobei das erste und das zweite Kühlgehäusebauteil (4,4',7,7') eine derartige Form aufweisen und derartig zueinander angeordnet sind, dass sich ein Hohlraum (18) an der den Leistungshalbleiterbauelementen (9) abgewandten Seite (D) der Kühlplatte (5) ausbildet, wobei die Kühlplatte (5) mittels einer um die Kühlplatte (5) umlaufenden ersten Schweißnaht (17) mit dem ersten Kühlgehäusebauteil (4,4') verbunden ist, wobei die erste Schweißnaht (17) die Kühlplatte (5) gegen das erste Kühlgehäusebauteil (4,4') abdichtet, wobei das zweite Kühlgehäusebauteil (7,7') mit dem ersten Kühlgehäusebauteil (4,4') verbunden ist.

2. Leistungshalbleitereinrichtung nach Anspruch 1, **dadurch gekennzeichnet, dass** die erste Schweißnaht (17), die lateralen Seitenflächen (15) der Kühlplatte mit die Ausnehmung (25) begrenzenden lateralen Seitenflächen (16) des ersten Kühlgehäusebauteils (4,4') verbindet.

3. Leistungshalbleitereinrichtung nach einem der vorhergehenden Ansprüchen, **dadurch gekennzeichnet, dass** die erste Schweißnaht (17) hohlraumseitig angeordnet ist.

4. Leistungshalbleitereinrichtung nach Anspruch 1 oder 2, **dadurch gekennzeichnet, dass** die erste Schweißnaht (17) an einer den Leistungshalbleiterbauelementen (9) zugewandten ersten Außenseite (A) des Kühlkörpers (2) angeordnet ist.

5. Leistungshalbleitereinrichtung nach einem der vorhergehenden Ansprüchen, **dadurch gekennzeichnet, dass** ein Abschnitt (16a) der die Ausnehmung (25) begrenzenden lateralen Seitenflächen (16) des ersten Kühlgehäusebauteils (4) eine zu einem Abschnitt (15a) der lateralen Seitenflächen (15) der Kühlplatte (5) korrespondierende Form aufweist.

6. Leistungshalbleitereinrichtung nach Anspruch 5, **dadurch gekennzeichnet, dass** der Abschnitt (15a) der lateralen Seitenflächen (15) der Kühlplatte (5) einen Winkel (α) zu einer den Leistungshalbleiterbauelementen (9) zugewandten Hauptfläche (14) der Kühlplatte von 91 ° bis 115° oder von 89° bis 65° aufweist und der Abschnitt (16a) der die Ausnehmung (25) begrenzenden lateralen Seitenflächen (16) des ersten Kühlgehäusebauteils (4,4') zu der den Leistungshalbleiterbauelementen (9) zugewandten Hauptfläche (14) der Kühlplatte (5) einen Winkel (β) aufweist, der gleich dem Winkel (α) des Abschnitts (15a) der lateralen Seitenflächen (15) der Kühlplatte (5) zu der den Leistungshalbleiterbauelementen (9) zugewandten Hauptfläche (14) der Kühlplatte (5) ist.

7. Leistungshalbleitereinrichtung nach einem der vorhergehenden Ansprüchen, **dadurch gekennzeichnet, dass** die Kühlplatte (5) in den Hohlraum (18) hineinreichende Kühlfinnen und/oder Kühlpins (19) aufweist.

8. Leistungshalbleitereinrichtung nach einem der vorhergehenden Ansprüchen, **dadurch gekennzeichnet, dass** die erste Schweißnaht (17) als Laserschweißnaht, Elektrodenstrahlschweißnaht oder Rührreibschweißnaht ausgebildet ist.

9. Leistungshalbleitereinrichtung nach einem der vorhergehenden Ansprüchen, **dadurch gekennzeichnet, dass** das zweite Kühlgehäusebauteil (7,7') mittels einer um das zweite Kühlgehäusebauteil (7,7') umlaufenden zweiten Schweißnaht (22,22') mit dem ersten Kühlgehäusebauteil (4,4') verbunden ist, wobei die zweite Schweißnaht (22,22') das zweite Kühlgehäusebauteil (7,7') gegen das erste Kühlgehäusebauteil (4,4') abdichtet.

10. Leistungshalbleitereinrichtung nach Anspruch 9, **dadurch gekennzeichnet, dass** das erste Kühlgehäusebauteil (4) das zweite Kühlgehäusebauteil (7) lateral umschließt, wobei die zweite Schweißnaht (22), die lateralen Seitenflächen (20) des zweiten Kühlgehäusebauteils (7) mit innenliegenden lateralen Seitenflächen (21) des ersten Kühlgehäusebauteils (4) verbindet.

11. Leistungshalbleitereinrichtung nach Anspruch 10, **dadurch gekennzeichnet, dass** die zweite Schweißnaht (22) an einer den Leistungshalbleiterbauelementen (9) abgewandten zweiten Außenseite (B) des Kühlkörpers (2) angeordnet ist.

12. Leistungshalbleitereinrichtung nach einem der Ansprüche 9, **dadurch gekennzeichnet, dass** das zweite Kühlgehäusebauteil (7') einen vom ersten Kühlgehäusebauteil (4') wegstehenden Bauch (28) aufweist, wobei die zweite Schweißnaht (22'), die lateralen Seitenflächen (20) des zweiten Kühlgehäusebauteils (7') mit einer den Leistungshalbleiterbauelementen (9) abgewandten ersten Hauptfläche (29) des ersten Kühlgehäusebauteils (4') verbindet.

13. Leistungshalbleitereinrichtung nach einem der Ansprüche 9 bis 12, **dadurch gekennzeichnet, dass** die zweite Schweißnaht (22,22') als Laserschweißnaht, Elektrodenstrahlschweißnaht oder Rührreibschweißnaht ausgebildet ist.

14. Verfahren zur Herstellung einer Leistungshalbleitereinrichtung mit folgenden Verfahrensschritten:
a) Bereitstellen eines Leistungshalbleitermoduls (3), das Leistungshalbleiterbauelemente (9), die auf elektrische leitenden Leiterbahnen (13) angeordnet sind, aufweist, wobei das Leistungshalbleitermodul (3) eine elektrisch nicht leitende Isolationsschicht (6) und eine Kühlplatte (5) aufweist, wobei die Isolationsschicht (6) zwischen den Leiterbahnen (9) und der Kühlplatte (5) angeordnet ist und Bereitstellen eines ersten Kühlgehäusebauteils (4,4'), das eine durch das erste Kühlgehäusebauteil (4,4') hindurchgehende Ausnehmung (25) aufweist und Bereitstellen eines zweiten Kühlgehäusebauteils (7,7'),
b) Anordnen der Kühlplatte (5) in der Ausnehmung (25) des ersten Kühlgehäusebauteils (4,4'),
c) Verschweißen der Kühlplatte (5) mit dem ersten Kühlgehäusebauteil (4,4') derart, dass eine um die Kühlplatte (5) umlaufende erste Schweißnaht (17) entsteht, die die Kühlplatte (5) gegen das erste Kühlgehäusebauteil (4,4') abdichtet, wobei das Verschweißen der Kühlplatte (5) mit dem ersten Kühlgehäusebauteil (4,4') an der den Leistungshalbleiterbauelementen (9) abgewandten Seite (D) der Kühlplatte (5) erfolgt,
d) Anordnen des zweiten Kühlgehäusebauteils (7,7') zum ersten Kühlgehäusebauteil (4,4'), wobei das Anordnen des zweiten Kühlgehäusebauteils (7,7') zum ersten Kühlgehäusebauteils (4,4') derartig erfolgt und das erste und zweite Kühlgehäusebauteil (4,4',7,7') eine derartige Form aufweisen, dass sich ein Hohlraum (18) an der den Leistungshalbleiterbauelementen (9) abgewandten Seite (D) der Kühlplatte (5) ausbildet und
e) Verbinden des zweiten Kühlgehäusebauteils (7,7') mit dem ersten Kühlgehäusebauteil (4,4').

15. Verfahren nach Anspruch 15, **dadurch gekennzeichnet, dass** das Verbinden des zweiten Kühlgehäusebauteils (7,7') mit dem ersten Kühlgehäusebauteil (4,4') durch Verschweißen des zweiten Kühlgehäusebauteils (7,7') mit dem ersten Kühlgehäusebauteil (4,4') erfolgt, wobei das Verschweißen des zweiten Kühlgehäusebauteils (7,7') mit dem ersten Kühlgehäusebauteil (4,4') derartig durchgeführt wird, dass das zweite Kühlgehäusebauteil (7,7') mittels einer um das zweite Kühlgehäusebauteil (7,7') umlaufenden zweiten Schweißnaht (22,22') mit dem ersten Kühlgehäusebauteil (4,4') verbunden wird, wobei die zweite Schweißnaht (22,22') das zweite Kühlgehäusebauteil (7,7') gegen das erste Kühlgehäusebauteil (4,4') abdichtet.
